(19) Europäisches Patentamt
European Patent Office
Office européen des brevets

(11) EP 3 651 363 A1

(12) DEMANDE DE BREVET EUROPEEN

(43) Date de publication:
13.05.2020 Bulletin 2020/20

(51) Int Cl.:
*H03K 19/00* (2006.01)

(21) Numéro de dépôt: 19202327.3

(22) Date de dépôt: 09.10.2019

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 09.11.2018 FR 1871437

(71) Demandeur: Commissariat à l'Energie Atomique
et aux Energies
Alternatives
75015 Paris (FR)

(72) Inventeurs:
• PILLONNET, Gaël
38054 GRENOBLE CEDEX 9 (FR)
• FANET, Hervé
38054 GRENOBLE CEDEX 9 (FR)

(74) Mandataire: Cabinet Beaumont
4, Place Robert Schuman
B.P. 1529
38025 Grenoble Cedex 1 (FR)

(54) CELLULE LOGIQUE ADIABATIQUE

(57) La présente description concerne une cellule logique (400) adiabatique comportant un premier transistor MOS (T1) reliant un noeud (a1) d'application d'une tension d'alimentation variable périodique ($\phi$n) de la cellule à un noeud flottant (s1) de fourniture d'un signal logique de sortie (VOUT1) de la cellule, dans laquelle le premier transistor (T1) est un transistor à double grilles comportant une grille de face avant (fg) reliée à un noeud (e1) d'application d'un signal logique d'entrée (VIN1) de la cellule, et une grille de face arrière (bg) reliée à un noeud (p1) d'application d'une première tension de polarisation variable périodique (VBG).

Fig 4

EP 3 651 363 A1

**Description**

Domaine technique

La présente demande concerne le domaine des circuits intégrés comportant des cellules mettant en oeuvre des fonctions logiques, aussi appelées cellules logiques ou portes logiques. La présente demande vise plus particulièrement des cellules logiques à faible consommation, et un circuit intégré comportant de telles cellules logiques.

Technique antérieure

Les circuits logiques de l'état de la technique sont généralement réalisés à base de transistors à effet de champ, par exemple en technologie CMOS (de l'anglais "Complementary Metal-Oxide Semiconductor") qui associe deux types de transistors MOS complémentaires, l'un de type N, l'autre de type P, sur un même support.

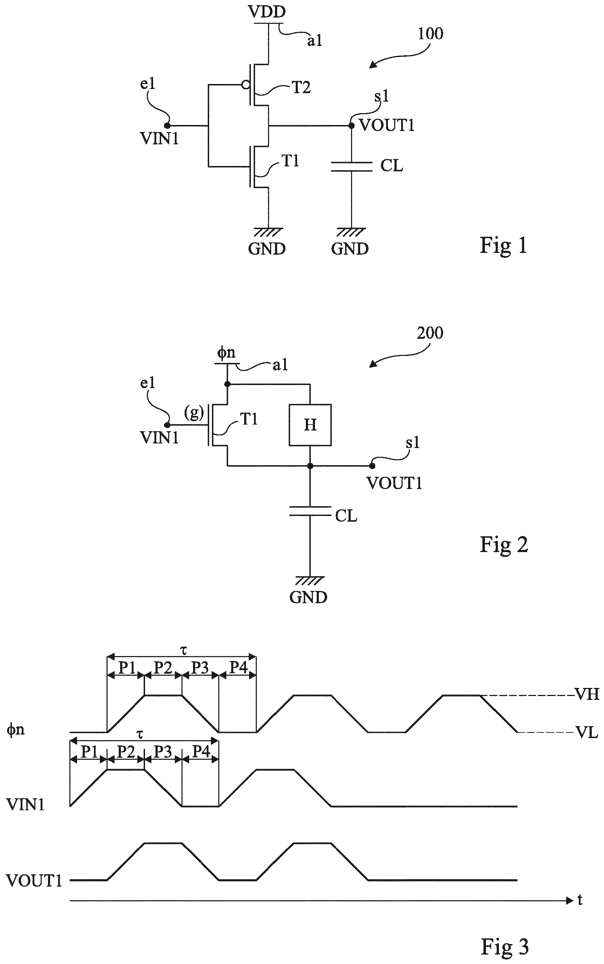

La figure 1 est un schéma électrique d'un exemple d'une cellule logique 100 inverseuse, c'est-à-dire réalisant la fonction de base NON, en technologie CMOS. La cellule 100 comprend une association en série d'un transistor MOS à canal N T1 et d'un transistor MOS à canal P T2 entre un noeud GND d'application d'un potentiel de référence du circuit (par exemple la masse) et un noeud a1 d'application d'une tension d'alimentation continue VDD référencée par rapport au noeud GND. Plus particulièrement, le transistor T1 a sa source connectée au noeud GND et son drain connecté au drain du transistor T2, et le transistor T2 a sa source connectée au noeud a1. Les grilles des transistors T1 et T2 sont connectées à un même noeud e1 d'application d'un signal logique d'entrée VIN1. Les drains des transistors T1 et T2 sont connectés à un même noeud s1 de fourniture d'un signal logique de sortie VOUT1. Dans cet exemple, les signaux d'entrée VIN1 et de sortie VOUT1 sont des tensions référencées par rapport au noeud GND. Sur la figure 1, un condensateur CL connecté entre le noeud de sortie s1 et le noeud de référence GND a été représenté, schématisant la capacité de sortie de la cellule.

Le fonctionnement de l'inverseur 100 de la figure 1 est le suivant. Lorsque le signal d'entrée VIN1 est à un état haut, par exemple à une valeur proche de la tension d'alimentation VDD, le transistor T2 est bloqué et le transistor T1 est passant. Il en résulte que le signal VOUT1 est maintenu à un état bas, proche de 0 volt. Lorsque le signal d'entrée VIN1 est à un état bas, par exemple à une valeur proche de 0 volt, le transistor T1 est bloqué et le transistor T2 est passant. Il en résulte que le signal VOUT1 est maintenu à un état haut, proche de VDD. La cellule de la figure 1 réalise donc bien une fonction d'inverseur, c'est-à-dire que le signal logique de sortie VOUT1 est égal au complément du signal logique d'entrée VIN.

Plus généralement, toutes les fonctions logiques de base usuellement utilisées dans les circuits intégrés peuvent être réalisées par des cellules présentant des architectures du même type que celle de la figure 1, c'est-à-dire comportant des transistors à effet de champ montés en ponts diviseurs de tension résistifs.

Les cellules logiques de ce type présentent toutefois des limitations en termes de consommation électrique. En particulier, on peut démontrer qu'une cellule du type décrit en relation avec la figure 1 dissipe, à chaque changement d'état de son signal d'entrée, une quantité d'énergie E donnée par la relation :

[Math 1]

$$E = 0,5 * CL * VDD^2$$

Pour réduire la consommation dynamique des cellules, on peut chercher à réduire leur tension d'alimentation VDD. Toutefois, en pratique, la réduction de la tension d'alimentation s'accompagne d'une diminution des tensions de seuil des transistors et par conséquent d'une augmentation des courants de fuite dans les transistors, et donc de la consommation statique des cellules.

Un autre type de cellules logiques, dites adiabatiques, a été proposé pour réduire la consommation des cellules. En logique adiabatique, plutôt que de charger et décharger brusquement les capacités de sortie CL des cellules à chaque changement d'état, comme cela est fait en logique classique, on cherche à réaliser les charges et décharges des capacités CL de façon progressive. Pour cela, la tension d'alimentation continue VDD utilisée en logique classique est remplacée par une tension d'alimentation variable périodique. La logique adiabatique est une logique dynamique, c'est-à-dire que les états de sortie des cellules logiques ne sont disponibles que pendant une fraction de la période du signal d'horloge formé par la tension d'alimentation variable périodique. Si l'on désigne par T la durée de charge ou de décharge de la capacité CL, par RT la résistance du transistor T1 ou T2 utilisé pour charger ou décharger la capacité CL, et si on considère une tension d'alimentation périodique variant de 0 volt à VDD, on peut montrer, en première approximation (en considérant la durée T comme très supérieure à la constante de temps RT*CL des cellules), que la quantité d'énergie E dissipée lors d'un changement d'état d'une cellule s'exprime par la relation :

[Math 2]

$$E = CL*VDD^2 * \frac{2*RT*CL}{T}$$

Ainsi, si la durée T de charge et de décharge des capacités CL des cellules (correspondant au temps de montée de 0 volt à VDD ou de descente de VDD à 0 volt de la tension d'alimentation) est choisie suffisamment élevée devant la constante de temps RT*CL des cellules, l'énergie dissipée à chaque changement d'état peut être réduite de façon significative par rapport à des circuits logiques classiques du type décrit en relation avec la figure 1.

En pratique, les circuits logiques adiabatiques réalisés en technologie CMOS présentent eux aussi des limitations en termes de consommation. En particulier, un transistor MOS présentant habituellement une tension de seuil non nulle, il subsiste inévitablement une dissipation énergétique non adiabatique résiduelle à chaque commutation des transistors de la cellule. La réduction de la tension de seuil des transistors dans les technologies CMOS avancées permet de réduire cette dissipation dynamique non adiabatique, mais s'accompagne généralement d'une augmentation des courants de fuite, et donc de la consommation statique des cellules, qui reste non négligeable du fait de la fréquence relativement faible de la tension d'alimentation variable périodique.

Résumé de l'invention

Un objet d'un mode de réalisation est de pallier tout ou partie des inconvénients des cellules logiques adiabatiques connues.

Pour cela, un mode de réalisation prévoit une cellule logique adiabatique comportant un premier transistor MOS reliant un noeud d'application d'une tension d'alimentation variable périodique de la cellule à un noeud flottant de fourniture d'un signal logique de sortie de la cellule, dans laquelle le premier transistor est un transistor à double grilles comportant une grille de face avant reliée à un noeud d'application d'un signal logique d'entrée de la cellule, et une grille de face arrière reliée à un noeud d'application d'une première tension de polarisation variable périodique, dans laquelle la tension de polarisation variable périodique et la tension d'alimentation variable périodique ont sensiblement la même fréquence et la même forme, et dans laquelle la tension de polarisation variable périodique varie sensiblement en phase ou en opposition de phase avec la tension d'alimentation variable périodique.

Selon un mode de réalisation, la tension de polarisation variable périodique est choisie de façon que le premier transistor présente une tension de seuil variant de façon périodique, sensiblement à la même fréquence que la tension d'alimentation variable périodique, et présente une valeur maximale lorsque la tension d'alimentation variable périodique présente une valeur maximale, et une tension de seuil minimale lorsque la tension d'alimentation variable périodique présente une valeur minimale.

Selon un mode de réalisation, la tension de polarisation variable périodique et la tension d'alimentation variable périodique ont sensiblement la même fréquence.

Selon un mode de réalisation, la tension de polarisation variable périodique varie en phase ou en opposition de phase avec la tension d'alimentation variable périodique.

Selon un mode de réalisation, la cellule comprend en outre un circuit de maintien connecté entre le noeud d'application de la tension d'alimentation et le noeud flottant de la cellule.

Selon un mode de réalisation, le circuit de maintien comprend un transistor MOS reliant, par ses noeuds de conduction, le noeud d'application de la tension d'alimentation au noeud flottant de la cellule.

Selon un mode de réalisation, la cellule comprend en outre un circuit de réinitialisation connecté entre le noeud flottant et un noeud d'application d'un potentiel de référence de la cellule.

Selon un mode de réalisation, le circuit de réinitialisation comprend un transistor MOS reliant, par ses noeuds de conduction, le noeud flottant au noeud d'application du potentiel de référence de la cellule.

Selon un mode de réalisation, la cellule comporte en outre un premier transistor MOS additionnel reliant le noeud d'application de la tension d'alimentation à un noeud flottant additionnel de fourniture d'un signal logique de sortie complémentaire de la cellule, le premier transistor MOS additionnel étant un transistor à double grilles comportant une grille de face avant reliée à un noeud d'application d'un signal logique d'entrée complémentaire de la cellule, et une grille de face arrière reliée au noeud d'application de la première tension de polarisation de la cellule.

Selon un mode de réalisation, la cellule comporte en outre un circuit de maintien additionnel, le circuit de maintien additionnel comprenant un transistor MOS reliant, par ses noeuds de conduction, le noeud d'application de la tension d'alimentation au noeud flottant additionnel de la cellule.

Selon un mode de réalisation, le transistor du circuit de maintien a une grille de face avant connectée au noeud flottant additionnel de la cellule et le transistor du circuit de maintien additionnel a une grille de face avant connectée au noeud flottant de la cellule.

Selon un mode de réalisation, le premier transistor et le premier transistor additionnel de la cellule sont de même type de conductivité, et le transistor du circuit de maintien et le transistor du circuit de maintien additionnel sont de type de conductivité opposé à celui du premier transistor et du premier transistor additionnel.

Selon un mode de réalisation, le transistor du circuit de maintien et le transistor du circuit de maintien additionnel sont des transistors à double grilles ayant une grille de face arrière reliée à un noeud d'application d'une deuxième tension de polarisation variable périodique.

Selon un mode de réalisation, la cellule comporte en outre un circuit de réinitialisation additionnel, le circuit de réinitialisation additionnel comprenant un transistor MOS reliant, par ses noeuds de conduction, le noeud flottant additionnel au noeud d'application du potentiel de référence de la cellule.

Selon un mode de réalisation, le transistor du circuit de réinitialisation a une grille de face avant connectée au noeud flottant additionnel de la cellule et le transistor du circuit de réinitialisation additionnel a une grille de face avant connectée au noeud flottant de la cellule.

Selon un mode de réalisation, le transistor du circuit de réinitialisation et le transistor du circuit de réinitialisation additionnel sont des transistors à double grilles ayant chacun une grille de face arrière reliée au noeud d'application de la première tension de polarisation de la cellule.

Un autre mode de réalisation prévoit un circuit logique comportant une première cellule logique telle que définie ci-dessus et une deuxième cellule logique telle que définie ci-dessus cascadée en série avec la première cellule, la première cellule ayant son noeud flottant connecté au noeud d'application du signal logique d'entrée de la deuxième cellule.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, précédemment décrite, est un schéma électrique d'un exemple d'une cellule logique statique ;

la figure 2 est un schéma électrique d'un exemple d'une cellule logique adiabatique ;

la figure 3 est chronogramme illustrant un exemple d'un mode de fonctionnement de la cellule de la figure 2 ;

la figure 4 est un schéma électrique d'un exemple d'une cellule logique adiabatique selon un mode de réalisation ;

la figure 5 est un chronogramme illustrant un exemple d'un mode de fonctionnement de la cellule de la figure 4 ;

la figure 6 est un chronogramme illustrant un autre exemple d'un mode de fonctionnement de la cellule de la figure 4 ;

la figure 7 est un schéma électrique illustrant plus en détail un exemple de réalisation de la cellule de la figure 4 ;

la figure 8 est un schéma électrique illustrant un autre exemple de réalisation d'une cellule logique adiabatique selon un mode de réalisation ;

la figure 9 est un schéma électrique d'une variante de réalisation de la cellule de la figure 4 ;

la figure 10 est un schéma électrique d'un autre exemple de réalisation d'une cellule logique adiabatique selon un mode de réalisation ; et

la figure 11 est un chronogramme illustrant un autre exemple d'un mode de fonctionnement d'une cellule logique adiabatique selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les utilisations qui peuvent être faites des cellules logiques élémentaires décrites n'ont pas été détaillée, les modes de réalisation décrits étant compatibles avec les utilisations usuelles de cellules logiques élémentaires dans des circuits électroniques. De plus, la réalisation des différents composants, et notamment des transistors, des cellules décrites, n'a pas été détaillée, les modes de réalisation décrits étant compatibles avec les techniques connues de réalisation de transistors MOS.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

Dans les exemples décrits, les signaux logiques d'entrée et de sortie d'une cellule logique correspondent à des tensions référencées par rapport à un noeud de référence GND de la cellule, dont le niveau détermine la valeur, haute ou basse, du signal logique. Sauf précision contraire, on entend par signal logique un signal ne pouvant prendre que deux valeurs, une valeur haute, correspondant par exemple à une tension proche de la tension d'alimentation de la cellule, ou une valeur basse, correspondant par exemple à une tension proche de 0 volt. On s'intéresse ici plus particulièrement à la réalisation de cellules logiques adiabatiques. Dans ce cas, la tension d'alimentation de chaque cellule est une tension variable périodique, et les signaux logiques d'entrée et de sortie de chaque cellule correspondent à des tensions variables ou tensions alternatives de même fréquence que la tension d'alimentation, dont l'amplitude détermine la valeur, haute ou basse, du signal logique. A titre d'exemple, un signal logique est dit à l'état haut (1 logique) lorsque l'amplitude de la tension correspondante est proche de l'amplitude de la tension d'alimentation de la cellule, par exemple comprise entre 1 et 10 volts, et à l'état bas (0 logique) lorsque l'amplitude de la tension correspondante est proche de 0 volt, par exemple inférieure à 0,5 volt.

La figure 2 est un schéma électrique d'un exemple d'une cellule logique adiabatique 200 de type buffer.

La cellule 200 comprend un transistor MOS à canal N T1 reliant, par ses noeuds de conduction, un noeud a1 d'application d'une tension d'alimentation variable périodique φn de la cellule, à un noeud s1 de fourniture d'une tension de sortie VOUT1 de la cellule. Plus particulièrement, le transistor T1 a son drain relié, par exemple connecté, au noeud a1 et sa source reliée, par exemple connectée, au noeud s1. La grille (g) du transistor T1 est reliée, par exemple connectée, à un noeud e1 d'application d'une tension d'entrée VIN1 de la cellule. Sur la figure 2, un condensateur CL connecté entre le noeud de sortie s1 et le noeud de référence GND a été représenté, schématisant la capacité de sortie de la cellule. A titre d'exemple, la capacité de sortie CL ne correspond pas à un composant spécifiquement réalisé et connecté au noeud de sortie s1 de la cellule, mais représente la somme des capacités parasites des différents éléments connectés au noeud s1, notamment des pistes d'interconnexion, du transistor T1, ou encore une autre cellule logique (non représentée) dont l'entrée est connectée au noeud s1. Dans cet exemple, la tension d'alimentation φn est référencée par rapport au noeud GND. De plus, dans cet exemple, les tensions d'entrée VIN1 et de sortie VOUT1 sont des tensions variables de même fréquence que la tension φn, référencées par rapport au noeud GND.

Dans l'exemple de la figure 2, la cellule buffer 200 comprend en outre un circuit de maintien H adapté à maintenir la tension de sortie VOUT1 de la cellule à un niveau haut lors de phases de transition de la tension d'entrée VIN1 d'un niveau haut à un niveau bas. Dans cet exemple, le circuit de maintien H est connecté d'une part au noeud d'alimentation a1 et d'autre part au noeud de sortie s1 de la cellule.

La figure 3 est un chronogramme illustrant le fonctionnement de la cellule buffer 200 de la figure 2. Plus particulièrement, la figure 3 illustre l'évolution, en fonction du temps t (en abscisse), de la tension d'alimentation φn, de la tension d'entrée VIN1, et de la tension de sortie VOUT1 de la cellule de la figure 2.

La tension d'alimentation φn est une tension variable périodique, fournie par une source de tension variable non représentée en figure 2. La tension φn varie de façon périodique et continue entre une valeur basse VL, par exemple comprise entre 0 et 2 volts, et une valeur haute VH, par exemple supérieure d'au moins 1 volt à la valeur VL. Dans l'exemple représenté, la tension d'alimentation φn est une tension trapézoïdale. Plus particulièrement, dans cet exemple, chaque période $\tau$ de la tension φn comprend quatre phases successives P1, P2, P3 et P4 sensiblement de même durée T=$\tau$/4. Lors de la phase P1, la tension φn croit linéairement depuis sa valeur basse VL jusqu'à sa valeur haute VH. Lors de la phase P2, la tension φn reste sensiblement constante et égale à sa valeur haute VH. Lors de la phase P3, la tension φn décroit linéairement depuis sa valeur haute VH jusqu'à sa valeur basse VL. Lors de la phase P4, la tension φn reste sensiblement constante et égale à sa valeur basse VL.

Les tensions VIN1 et VOUT1 sont synchronisées sur la tension d'alimentation φn, qui sert aussi de signal d'horloge. Les tensions VIN1 et VOUT1 ont sensiblement la même forme que la tension d'alimentation variable φn. Les tensions VIN1 et VOUT1 définissent respectivement des signaux logiques IN1 et OUT1. Le signal logique IN1, respectivement OUT1, est à un état haut lorsque l'amplitude de la tension variable VIN1, respectivement VOUT1, est à un niveau haut, par exemple proche de l'amplitude de la tension d'alimentation φn, par exemple sensiblement égal à l'amplitude de la tension d'alimentation φn moins la tension de seuil VTH du transistor T1, et est à un niveau bas lorsque l'amplitude de la tension variable VIN1, respectivement VOUT1, est à un niveau bas, par exemple proche de 0 volt, par exemple sensiblement égal à la tension de seuil VTH dans le cas où le circuit de maintien est constitué d'un transistor identique ou similaire au transistor T1 comme cela sera décrit plus en détail ci-après. La tension VIN1 présente une avance de phase de l'ordre de T=τ/4, soit π/2 radians ou 90 degrés, sur la tension d'alimentation φn. La tension VOUT1 est quant à elle en phase avec la tension d'alimentation φn.

Dans l'exemple représenté en figure 3, le signal logique d'entrée IN1 est à l'état haut pendant deux périodes τ successives du signal d'alimentation φn, puis passe à l'état bas.

Pour un 0 logique du signal d'entrée IN1 (tension VIN1 d'amplitude proche de 0 volt), la résistance du transistor T1 est à une valeur haute (correspondant par exemple à la résistance à l'état bloqué du transistor) pendant les quatre phases P1, P2, P3 et P4 de la tension VIN1, de sorte que la capacité CL ne se charge pas ou peu. L'impulsion de tension VOUT1 transmise sur la borne de sortie s1 de la cellule est alors à un niveau d'amplitude bas, par exemple proche de 0 volt. Pour un 1 logique du signal d'entrée IN1 (tension VIN1 d'amplitude proche de l'amplitude de la tension d'alimentation φn), la résistance du transistor T1 diminue jusqu'à une valeur basse (correspondant par exemple à la résistance à l'état passant du transistor) pendant la phase P1 de la tension VIN1, reste à une valeur basse pendant la phase P2 de la tension VIN1, augmente à nouveau jusqu'à une valeur haute pendant la phase P3 de la tension VIN1, puis reste à une valeur haute pendant la phase P4 de la tension VIN1. On obtient alors sur la borne de sortie s1 de la cellule une impulsion de tension VOUT1 présentant un niveau d'amplitude haut, par exemple proche de l'amplitude de la tension d'alimentation φn. Le circuit de maintien H de la cellule permet de maintenir une résistance relativement basse entre les bornes d'alimentation a1 et de sortie s1 de la cellule, pendant la phase de décroissance de l'impulsion de niveau haut de la tension d'entrée VIN1 (phase P3 de la tension VIN1, correspondant à la phase P2 de la tension Φn), ce qui permet de fournir en sortie de la cellule une impulsion de niveau haut de même forme (trapézoidale dans cette exemple) que la tension d'alimentation φn.

Ainsi, la cellule 200 recopie sur sa borne de sortie s1 un signal OUT1 ayant le même état logique que le signal IN1 appliqué sur sa borne d'entrée e1.

Dans l'exemple décrit ci-dessus d'un fonctionnement à quatre phases, dans un circuit logique comportant plusieurs cellules cascadées en série, chaque cellule reçoit, sur sa borne d'alimentation a1 une tension variable périodique φn en retard de phase d'environ T=τ/4 sur la tension d'alimentation de la cellule précédente. Ceci permet que, dans chaque cellule, le signal logique d'entrée de la cellule (correspondant au signal logique de sortie de la cellule précédente) soit en avance de phase d'environ T=τ/4 sur la tension d'alimentation de la cellule comme illustré en figure 3. Ainsi, dans un circuit logique comportant un nombre supérieur ou égal à 4 de cellules élémentaires cascadées en série, on prévoira quatre tensions d'alimentation φ1, φ2, φ3, φ4 similaires, c'est-à-dire de même fréquence, de même forme et de même niveau d'amplitude, mais déphasées deux à deux d'environ π/2.

A titre de variante, les tensions d'alimentation trapézoïdales φn peuvent être approximées par des tensions sinusoïdales de période τ.

Une limitation de la cellule 200 de la figure 2 est que le transistor T1 présente une tension de seuil VTH non nulle, ce qui se traduit par une dissipation énergétique non adiabatique résiduelle à la fin de la phase P3 de la tension d'alimentation φn (en raison du non retour d'une partie des charges vers le noeud d'alimentation a1). Diminuer la tension de seuil du transistor T1 peut permettre de limiter voire de supprimer cette dissipation énergétique non adiabatique. Toutefois ceci conduit à augmenter les fuites dans le transistor T1, et donc la consommation énergétique, pendant la phase P2 de la tension d'alimentation φn.

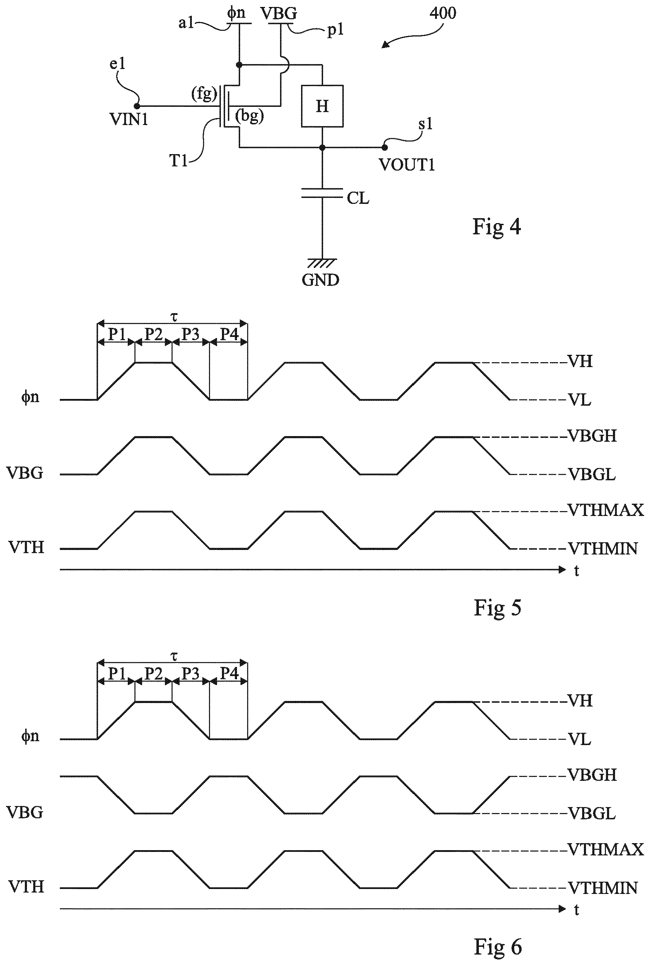

La figure 4 est un schéma électrique d'un exemple d'une cellule logique adiabatique 400 de type buffer selon un mode de réalisation.

La cellule 400 de la figure 4 diffère de la cellule 200 de la figure 2 essentiellement en ce que, dans la cellule 400, le transistor T1 est un transistor MOS à double grilles.

Par transistor MOS à double grilles, on entend ici un transistor comprenant une région de formation de canal bordée latéralement d'une part par une région de source et d'autre part par une région de drain, et comportant en outre une première grille de commande ou grille de face avant (fg), disposée au-dessus de la région de formation de canal et isolée de la région de formation de canal par une couche diélectrique, et une deuxième grille de commande ou grille de face arrière (bg), disposée sous la région de formation de canal. Dans un tel transistor, le courant circulant entre le drain et la source du transistor est fonction non seulement du potentiel appliqué sur la grille de face avant du transistor, mais aussi du potentiel appliqué sur sa grille de face arrière. En particulier, la tension de seuil du transistor, c'est-à-dire la tension minimale à appliquer entre la grille de face avant et la source du transistor pour rendre le transistor passant, dépend du potentiel appliqué sur la grille de face arrière du transistor.

Le transistor T1 est par exemple un transistor de type SOI (de l'anglais "Semiconductor On Insulator" - semiconducteur sur isolant), la grille de face arrière étant alors isolée de la région de formation de canal par une couche diélectrique. De préférence, le transistor T1 est un transistor de type FDSOI (de l'anglais "Fully Depleted Semiconductor On Insulator" - semiconducteur entièrement déplété sur isolant), c'est-à-dire un transistor SOI dans lequel la région de formation de canal est entièrement déplétée en l'absence de polarisation du transistor. En effet, dans un transistor FDSOI, les variations du potentiel de commande appliqué sur la grille de face arrière du transistor provoquent des variations significatives de la tension de seuil du transistor, ce qui est particulièrement adapté à la mise en oeuvre des modes de réalisation qui vont être décrits, comme cela ressortira plus clairement de la suite de la description. Les modes de réalisation décrits ne se limitent toutefois pas au cas où le transistor T1 est de type SOI ou FDSOI. Plus généralement, les modes de réalisation décrits s'appliquent à tous types de transistors MOS à deux grilles de commande disposées respectivement du côté de la face avant et du côté de la face arrière de la région de formation de canal du transistor.

A titre d'exemple, les modes de réalisation décrits sont compatibles avec des transistors MOS de type "bulk", comportant une région de corps semiconductrice disposée sous la région de formation de canal, dont la face supérieure est en contact avec la face inférieure de la région de formation de canal. Dans ce cas, la grille de face arrière est constituée par la région de corps du transistor, et n'est pas isolée de la région de formation de canal. A titre de variante, le transistor T1 peut être un transistor de type FinFET (ou transistor à ailette).

Le montage du transistor T1 de la figure 4 est similaire à ce qui a été décrit en relation avec la figure 2, en remplaçant la grille (g) du transistor T1 de la cellule de la figure 2 par la grille de face avant (fg) du transistor T1 dans la cellule de la figure 4.

Dans la cellule 400, la grille de face arrière (bg) du transistor T1 est reliée, par exemple connectée, à un noeud p1 d'application d'une tension variable périodique de polarisation VBG, sensiblement de même fréquence que la tension d'alimentation φn de la cellule. La tension de polarisation VBG permet de moduler la tension de seuil du transistor T1, sensiblement à la même fréquence que la tension d'alimentation φn de la cellule. Plus particulièrement, la tension de polarisation VBG est choisie de façon que la tension de seuil VTH du transistor T1 ait une valeur VTHMAX relativement haute pendant la phase P2 de la tension d'alimentation φn de la cellule, et une valeur VTHMIN relativement basse pendant la phase P4 de la tension d'alimentation φn de la cellule. De préférence, la tension de polarisation VBG est une tension à variation continue (ou progressive), de façon que la tension de seuil VTH varie de façon continue, par exemple de façon sensiblement linéaire, de la valeur haute VTHMAX à la valeur basse VTHMIN pendant la phase P3 de la tension d'alimentation φn, et de la valeur basse VTHMIN à la valeur haute VTHMAX pendant la phase P1 de la tension d'alimentation φn de la cellule. Ceci permet d'obtenir une charge et une décharge adiabatique de la grille de face arrière, de façon à éviter toute perte dynamique supplémentaire. A titre d'exemple, la tension de polarisation VBG est sensiblement de même forme, par exemple trapézoïdale ou sinusoïdale, que la tension d'alimentation φn.

La figure 5 est chronogramme illustrant un exemple d'un mode de fonctionnement de la cellule buffer 400 de la figure 4. Plus particulièrement, la figure 5 illustre l'évolution, en fonction du temps t (en abscisse), de la tension d'alimentation φn, de la tension de polarisation VBG appliquée sur le noeud p1 de la cellule, et de la tension de seuil VTH du transistor T1 de la cellule. Dans cet exemple, la tension d'alimentation φn de la cellule 400 est identique ou similaire à la tension d'alimentation φn de la cellule 200. Par souci de simplification, les tensions d'entrée VIN1 et de sortie VOUT1 de la cellule n'ont pas été représentées sur la figure 5. L'évolution des tensions VIN1 et VOUT1 est par exemple similaire à ce qui a été décrit en relation avec la figure 3. Toutefois, cette fois, les niveaux haut et bas de la tension VOUT1 ne sont plus limités par la tension de seuil VTH du transistor T1, ou seulement de façon négligeable.

Dans cet exemple, le transistor T1 est un transistor à variation positive de tension de seuil, c'est-à-dire que plus la tension de polarisation VBG appliquée sur sa grille arrière (bg) est élevée, plus sa tension de seuil VTH est élevée. Dans ce cas, comme cela apparaît sur la figure 5, la tension de polarisation VBG varie sensiblement en phase avec la tension d'alimentation φn. En pratique, un léger déphasage peut être présent du fait d'éventuelles différences de pentes de montée et/ou de descente entre la tension de polarisation VBG et la tension d'alimentation φn. Ainsi, par sensiblement en phase, on entend ici que le déphasage entre la tension de polarisation VBG et la tension d'alimentation φn est relativement faible, par exemple inférieur à 30 degrés et de préférence inférieur à 20 degrés en valeur absolue.

La tension VBG peut être fournie par une source de tension variable, non représentée sur la figure 4. La tension VBG varie de façon périodique et continue entre une valeur basse VBGL, et une valeur haute VBGH. A titre d'exemple, dans le cas où le transistor T1 est un transistor FDSOI, et où les valeurs haute et basse de la tension d'alimentation φn sont respectivement de l'ordre de 0 volt et de l'ordre de 1 volt, la valeur VBGL peut être comprise entre -2 et 0 volt, par exemple de l'ordre de -0,5 volt, et la valeur VBGH peut être supérieure d'au moins 1 volt à la valeur basse VBGL, par exemple comprise entre 1 et 4 volts, par exemple de l'ordre de 2 volts. Dans l'exemple représenté, la tension VBG est une tension trapézoïdale sensiblement de même forme que la tension d'alimentation φn et en phase avec la tension d'alimentation φn. Plus particulièrement, dans cet exemple, pendant la phase P1 de la tension φn, la tension VBG croit linéairement depuis sa valeur basse VBGL jusqu'à sa valeur haute VBGH. Lors de la phase P2 de la tension φn, la tension VBG reste sensiblement constante et égale à sa valeur haute VBGH. Lors de la phase P3 de la tension φn, la tension VBG décroit linéairement depuis sa valeur haute VBGH jusqu'à sa valeur basse VBGL. Lors de la phase P4 de la tension φn, la tension VBG reste sensiblement constante et égale à sa valeur basse VBGL. Il en résulte que, pendant la phase P1 de la tension φn, la tension de seuil VTH du transistor T1 croit linéairement depuis sa valeur basse VTHMIN jusqu'à sa valeur haute VTHMAX. Lors de la phase P2 de la tension φn, la tension VTH reste sensiblement constante et égale à sa valeur haute VTHMAX. Lors de la phase P3 de la tension φn, la tension VTH décroit linéairement depuis sa valeur haute VTHMAX jusqu'à sa valeur basse VTHMIN. Lors de la phase P4 de la tension φn, la tension VTH reste sensiblement constante et égale à sa valeur basse VTHMIN.

La figure 6 est chronogramme similaire au chronogramme de la figure 5, illustrant un exemple d'un mode de fonctionnement de la cellule buffer 400 de la figure 4 dans le cas où le transistor T1 est un transistor à variation négative de tension de seuil, c'est-à-dire que plus la tension de polarisation VBG appliquée sur sa grille arrière (bg) est élevée, plus sa tension de seuil VTH est faible. Dans ce cas, comme cela apparaît sur la figure 6, la tension de polarisation VBG varie sensiblement en opposition de phase avec la tension d'alimentation φn. En pratique, un léger déphasage peut être présent du fait d'éventuelles différences de pentes de montée et/ou de descente entre la tension de polarisation VBG et la tension d'alimentation φn. Ainsi, par sensiblement en opposition de phase, on entend ici que le déphasage entre la tension de polarisation VBG et la tension d'alimentation φn est égal à 180 degrés à plus ou moins 30 degrés près et de préférence à plus ou moins 20 degrés près.

Plus particulièrement, dans l'exemple représenté, la tension VBG est une tension trapézoïdale sensiblement de même forme que la tension d'alimentation φn, mais en opposition de phase avec la tension d'alimentation φn. Plus particulièrement, dans cet exemple, pendant la phase P1 de la tension φn, la tension VBG décroit linéairement depuis sa valeur haute VBGH jusqu'à sa valeur basse VBGL. Lors de la phase P2 de la tension φn, la tension VBG reste sensiblement constante et égale à sa valeur basse VBGL. Lors de la phase P3 de la tension φn, la tension VBG croit linéairement depuis sa valeur basse VBGL jusqu'à sa valeur haute VBGH. Lors de la phase P4 de la tension φn, la tension VBG reste sensiblement constante et égale à sa valeur haute VBGH. Il en résulte que, pendant la phase P1 de la tension φn, la tension de seuil VTH du transistor T1 croit linéairement depuis sa valeur basse VTHMIN jusqu'à sa valeur haute VTHMAX. Lors de la phase P2 de la tension φn, la tension VTH reste sensiblement constante et égale à sa valeur haute VTHMAX. Lors de la phase P3 de la tension φn, la tension VTH décroit linéairement depuis sa valeur haute VTHMAX jusqu'à sa valeur basse VTHMIN. Lors de la phase P4 de la tension φn, la tension VTH reste sensiblement constante et égale à sa valeur basse VTHMIN.

Un avantage de la cellule 400 de la figure 4 est que la tension de seuil du transistor T1 peut être rendue faible, par exemple inférieure à 0,1 volt, voire nulle, à la fin de la phase P3 de la tension d'alimentation φn, et relativement élevée, par exemple supérieure à 0,3 volt, pendant la phase P2 de la tension d'alimentation φn. Ceci permet de satisfaire les deux objectifs contradictoires de réduction de la dissipation énergétique non adiabatique de la cellule pendant la phase P3, et de réduction de la consommation statique liée aux fuites dans le transistor T1 pendant la phase P2.

En inversant les types de conductivité des transistors T1, on obtient une cellule inverseuse, c'est à dire réalisant la fonction logique NON. Plus généralement, toutes les fonctions logiques de base usuellement utilisées dans les circuits intégrés, par exemple les fonctions ET, OU, NON ET et NON OU, peuvent être réalisées par des cellules présentant des architectures du même type que celle de la figure 4, c'est-à-dire comportant un ou plusieurs transistors à effet de champ à double grilles reliés en série et/ou ou en parallèle entre un noeud d'alimentation a1 de la cellule et un noeud de sortie s1 de la cellule, chaque transistor ayant sa grille de face avant (fg) reliée à un noeud d'application d'un signal logique d'entrée de la cellule et sa grille de face arrière (bg) reliée à un noeud d'application d'une tension de polarisation variable périodique de même fréquence que la tension d'alimentation de la cellule.

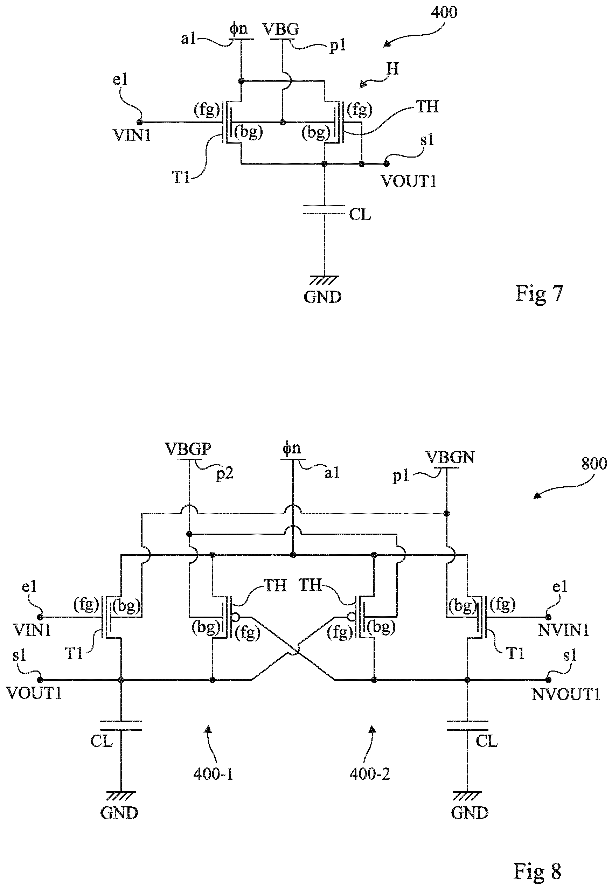

La figure 7 est un schéma électrique illustrant plus en détail un exemple de réalisation de la cellule 400 de la figure 4. La figure 7 reprend les mêmes éléments que la figure 4, et illustre plus particulièrement un exemple de réalisation du circuit de maintien H de la cellule 400 de la figure 4.

Dans l'exemple de la figure 7, le circuit de maintien H est constitué d'un transistor MOS TH reliant, par ses noeuds de conduction, le noeud de sortie s1 de la cellule à son noeud d'alimentation a1, la grille de commande du transistor TH étant reliée au noeud de sortie s1 de la cellule. Dans l'exemple de la figure 7, le transistor TH est un transistor de même type de conductivité que le transistor T1, c'est-à-dire à canal N dans l'exemple considéré. Dans cet exemple, la source du transistor TH est reliée, par exemple connectée, au noeud s1, et le drain du transistor TH est relié, par exemple connecté, au noeud a1. Dans cet exemple, le transistor TH est un transistor à double grilles dont la grille de face avant (fg) est reliée, par exemple connectée, au noeud s1, et dont la grille de face arrière est reliée, par exemple connectée, au noeud p1.

Lorsque la tension d'entrée VIN1 revient à sa valeur basse à la suite d'une impulsion de niveau haut (phase P3 de la tension VIN1, correspondant à la phase P2 des tensions φn et VOUT1), le transistor TH se substitue au transistor T1 pour maintenir la tension VOUT1 à un niveau haut.

Plus généralement, tout autre circuit permettant de maintenir entre les bornes a1 et s1, pendant la phase de décroissance de l'impulsion de niveau haut de la tension d'entrée VIN1 de la cellule (phase P3 de la tension VIN1), une résistance relativement basse par rapport à la résistance à l'état bloqué du transistor T1, peut être utilisé en remplacement du circuit H de la figure 7.

La figure 8 est un schéma électrique illustrant un autre exemple d'un mode de réalisation d'une cellule élémentaire 800 en logique adiabatique. La figure 8 illustre plus particulièrement un autre exemple de réalisation de la fonction de maintien, en reliant en parallèle deux cellules logiques identiques recevant des signaux logiques d'entrée complémentaires. Dans l'exemple de la figure 8, la cellule 800 est une cellule buffer/inverseur.

La cellule 800 de la figure 8 comprend deux cellules buffer 400_1 et 400_2. Les cellules 400_1 et 400_2 sont identiques ou similaires à la cellule 400 de la figure 7, à ceci près que :

- dans chacune des cellules 400_1 et 400_2, le transistor TH du circuit de maintien est de type de conductivité opposé au transistor T1 de la cellule, c'est-à-dire de type P dans cet exemple ;
- dans la cellule 400_1, la grille de face avant (fg) du transistor TH est reliée non pas à la borne de sortie s1 de la cellule 400_1, mais à la borne de sortie s1 de la cellule 400_2 ;
- dans la cellule 400_2, la grille de face avant (fg) du transistor TH est reliée non pas à la borne de sortie s1 de la cellule 400_2, mais à la borne de sortie s1 de la cellule 400_1 ; et
- dans chacune dans cellules 400_1 et 400_2, la grille de face arrière (bg) du transistor TH est reliée non pas au noeud p1 mais à un noeud p2 d'application d'une tension de polarisation variable distincte de la tension de polarisation variable appliquée sur le noeud p1.

Les cellules 400_1 et 400_2 reçoivent la même tension d'alimentation φn sur leurs bornes d'alimentation a1 respectives, et ont leurs noeuds GND connectés à un même noeud d'application d'un potentiel de référence. En fonctionnement, la borne d'entrée e1 de la cellule 400_1 reçoit une tension d'entrée VIN1 représentative d'un signal logique d'entrée IN1 de la cellule 800, et la borne d'entrée e1 de la cellule 400_2 reçoit une tension d'entrée NVIN1 représentative d'un signal logique NIN1 complémentaire du signal IN1. Une tension de polarisation variable périodique VBGN de même fréquence que la tension d'alimentation φn, par exemple identique ou similaire à la tension VBG des exemples des figures 4 à 7, est appliquée sur le noeud de polarisation p1 de la cellule. Une tension de polarisation variable périodique VBGP identique ou similaire mais en opposition de phase avec la tension VBGN, est appliquée sur le noeud de polarisation p2 de la cellule.

La cellule 800 fournit, sur la borne de sortie s1 de la cellule 400_1, un signal logique OUT1 (sous la forme d'une tension variable périodique VOUT1) ayant le même état logique que le signal IN1, et, sur la borne de sortie s1 de la cellule 400_2, un signal logique NOUT1 (sous la forme d'une tension variable périodique NVOUT1) complémentaire du signal IN1.

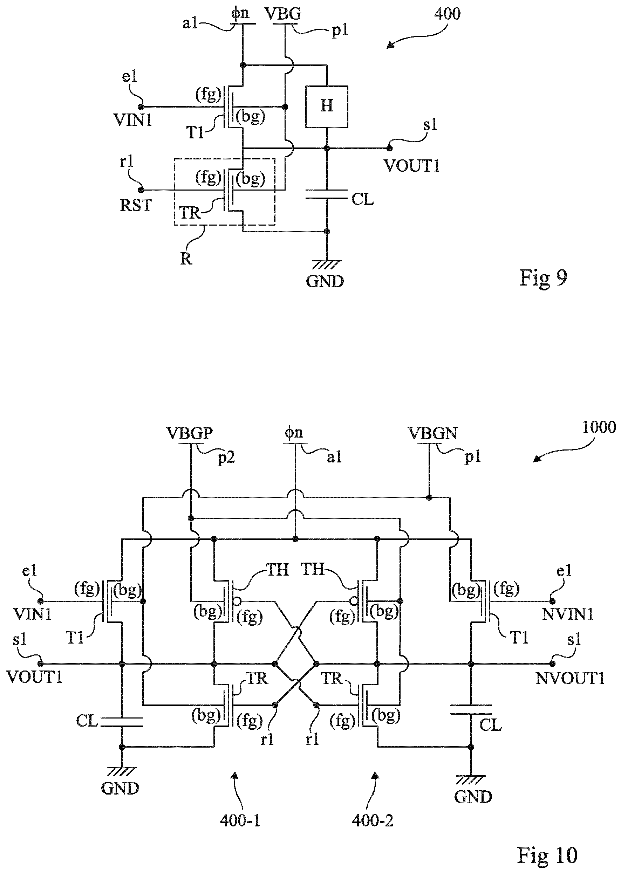

La figure 9 est un schéma électrique d'une variante de réalisation de la cellule buffer 400 de la figure 4.

Dans l'exemple de la figure 9, la cellule 400 comprend en outre un circuit de réinitialisation R permettant de réinitialiser à un potentiel de référence le noeud flottant de sortie s1 de la cellule. Dans cet exemple, le circuit de réinitialisation R comprend un transistor MOS TR reliant, par ses noeuds de conduction, le noeud s1 au noeud GND, la grille de commande du transistor TR étant reliée à un noeud r1 d'application d'un signal RST de commande en réinitialisation de la cellule. Le transistor TR est par exemple du même type de conductivité que le transistor T1. Les dimensions du transistor TR peuvent être différentes de celles du transistor T1. Les dimensions du transistor TR peuvent notamment être inférieures à celles du transistor T1 dans la mesure où le transistor TR sert uniquement à évacuer d'éventuelles charges électriques résiduelles accumulées sur le noeud s1.

Dans l'exemple représenté, le transistor TR a sa source reliée, par exemple connectée, au noeud GND et son drain relié, par exemple connecté, au noeud s1. Dans cet exemple, le transistor TR est un transistor MOS à double grilles, la grille de face avant (fg) du transistor TR étant reliée, par exemple connectée, au noeud r1 et la grille de face arrière (bg) du transistor TR étant reliée, par exemple connectée, au noeud p1.

La figure 10 illustre un exemple d'un mode de réalisation d'une cellule élémentaire 1000 en logique adiabatique.

La cellule 1000 combine les variantes de réalisation des figures 8 et 9. Plus particulièrement, la cellule 1000 comprend les même éléments que la cellule 800 de la figure 8, et comprend en outre, dans chacune des cellules 400_1 et 400_2, un transistor de réinitialisation TR, agencé de façon identique ou similaire a ce qui a été décrit dans l'exemple de la figure 9.

Dans cet exemple, le noeud de commande r1 du transistor de réinitialisation TR de la cellule 400_1 est relié, de préférence connecté, au noeud de sortie s1 de la cellule 400_2, et le noeud de commande r1 du circuit de réinitialisation TR de la cellule 400_2 est relié, de préférence connecté, au noeud de sortie s1 de la cellule 400_1. Ceci permet que le noeud de sortie s1 de la cellule 400_1 et le noeud de sortie s1 de la cellule 400_2 soient réinitialisés à chaque période du signal d'alimentation φn.

On a décrit ci-dessus des cellules élémentaires pour circuit logique adiabatique, compatibles avec un mode de fonctionnement du type décrit en relation avec la figure 3, permettant de cascader en série un nombre illimité de cellules en utilisant quatre signaux d'alimentation/horloge φ1, φ2, φ3 et φ4 déphasés deux à deux de 90 degrés. Les modes de réalisation décrits ne se limitent toutefois pas à ce mode de fonctionnement particulier. A titre de variante, on pourra prévoir un circuit logique fonctionnant avec une architecture d'alimentation/horloge dite rétractable, aussi appelée architecture à cadencement de Bennett (Bennett clocking en anglais).

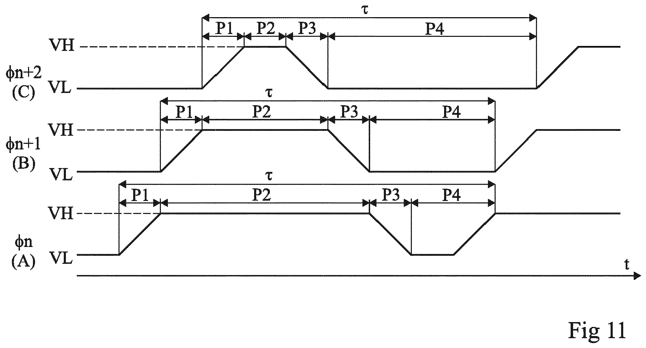

La figure 11 est un chronogramme illustrant un exemple de fonctionnement d'un circuit logique à cadencement de Bennett. On considère dans cet exemple un circuit comprenant trois cellules A, B et C, par exemple du type décrit ci-dessus, cascadées en série. Plus particulièrement, la cellule A, dite de rang n, a une borne de sortie reliée, par exemple connectée, à une borne d'entrée de la cellule B, dite de rang n+1, et la cellule B a une borne de sortie reliée, par exemple connectée, à une borne d'entrée de la cellule C, dite de rang n+2. La cellule A reçoit sur sa borne d'alimentation a1 une tension d'alimentation φn, la cellule B reçoit sur la borne d'alimentation a1 une tension d'alimentation φn+1, et la cellule C reçoit sur sa borne d'alimentation a1 une tension φn+2. Les tensions φn, φn+1 et φn+2 sont représentées sur la figure 11.

Chacune des tensions φn, φn+1 et φn+2 varie de façon périodique entre une valeur basse VL et une valeur haute VH. Comme cela apparaît sur la figure 11, les tensions φn, φn+1 et φn+2 ont sensiblement la même période τ. Toutefois, les tensions φn, φn+1 et φn+2 n'ont pas le même rapport cyclique. Dans cet exemple, le temps de montée de la valeur basse VL à la valeur haute VH (phase P1) et le temps de descente de la valeur haute VH à la valeur basse VL (phase P3) est sensiblement le même pour chacune des tensions φn, φn+1 et φn+2. Toutefois, le temps de maintien au niveau haut VH de la tension d'alimentation (phase P2) est plus élevé pour la tension φn que pour la tension φn+1 et plus élevé pour la tension φn+1 que pour la tension φn+2. Plus particulièrement, la phase P2 de la tension φn commence au début de la phase P1 de la tension φn+1 et se termine à la fin de la phase P3 de la tension φn+1, et la phase P2 de la tension φn+1 commence au début de la phase P1 de la tension φn+2 et se termine à la fin de la phase P3 de la tension φn+2. A l'inverse, le temps de maintien au niveau bas VL de la tension d'alimentation (phase P4) est plus faible pour la tension φn que pour la tension φn+1 et plus faible pour la tension φn+1 que pour la tension φn+2. Plus particulièrement, la phase P4 de la tension φn+2 commence au début de la phase P3 de la tension φn+1 et se termine à la fin de la phase P1 suivante de la tension φn+1, et la phase P4 de la tension φn+1 commence au début de la phase P3 de la tension φn+2 et se termine à la fin de la phase P1 suivante de la tension φn+2.

Dans ce mode de fonctionnement, le nombre de cellules logiques pouvant être cascadées en série est limité par le nombre de tensions d'alimentation φn imbriquées disponibles. Toutefois, un avantage est que les circuits de maintien H des cellules logiques décrites précédemment peuvent être omis.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, on a décrit ci-dessus des exemples de réalisation dans lesquels les tensions de polarisation variable VBG, VBGN, VBGP appliquées sur les grilles de face arrière des transistors sont fournies par des sources de tension distinctes de la source de tension d'alimentation φn (par exemple, dans la figure 4, le noeud p1 est distinct du noeud a1). Ceci est lié au fait que les tensions de polarisation variables VBG, VBGN, VBGP, bien qu'ayant sensiblement la même fréquence et la même forme que la tension d'alimentation φn, peuvent avoir des niveaux haut et bas différents des niveaux haut et bas de la tension φn. Toutefois, dans certains cas, selon le type de transistor utilisé, la tension d'alimentation φn pourra être directement appliquée sur les grilles de face arrière des transistors pour obtenir l'effet recherché, permettant ainsi de diminuer le nombre de sources de tension variables périodiques du circuit.

**Revendications**

1. Cellule logique (400 ; 800 ; 1000) adiabatique comportant un premier transistor MOS (T1) reliant un noeud (a1) d'application d'une tension d'alimentation variable périodique (φn) de la cellule à un noeud flottant (s1) de fourniture d'un signal logique de sortie (VOUT1) de la cellule, dans laquelle le premier transistor (T1) est un transistor à double grilles comportant une grille de face avant (fg) reliée à un noeud (e1) d'application d'un signal logique d'entrée (VIN1) de la cellule, et une grille de face arrière (bg) reliée à un noeud (p1) d'application d'une première tension de polarisation variable périodique (VBG ; VBGN), dans laquelle la tension de polarisation variable périodique (VBG ; VBGN) et la tension d'alimentation variable périodique (φn) ont sensiblement la même fréquence et la même forme.

2. Cellule logique (400 ; 800 ; 1000) selon la revendication 1, dans laquelle la tension de polarisation variable périodique (VBG ; VBGN) varie sensiblement en phase ou en opposition de phase avec la tension d'alimentation variable périodique (φn).

3. Cellule logique (400 ; 800 ; 1000) selon la revendication 1 ou 2, dans laquelle la tension de polarisation variable périodique (VBG ; VBGN) est choisie de façon que le premier transistor (T1) présente une tension de seuil variant de façon périodique, sensiblement à la même fréquence que la tension d'alimentation variable périodique (φn), et présente une valeur maximale (VTHMAX) lorsque la tension d'alimentation variable périodique (φn) présente une valeur maximale, et une valeur minimale (VTHMIN) lorsque la tension d'alimentation variable périodique (φn) présente une valeur minimale.

4. Cellule logique (400 ; 800 ; 1000) selon l'une quelconque des revendications 1 à 3, comprenant en outre un circuit de maintien (H) connecté entre le noeud (a1) d'application de la tension d'alimentation et le noeud flottant (s1) de la cellule.

5. Cellule logique (400 ; 800 ; 1000) selon la revendication 4, dans laquelle le circuit de maintien (H) comprend un transistor MOS (TH) reliant, par ses noeuds de conduction, le noeud (a1) d'application de la tension d'alimentation au noeud flottant (s1) de la cellule.

6. Cellule logique (400 ; 800 ; 1000) selon l'une quelconque des revendications 1 à 5, comprenant en outre un circuit de réinitialisation (R) connecté entre le noeud flottant (s1) et un noeud (GND) d'application d'un potentiel de référence de la cellule.

7. Cellule logique (400 ; 800 ; 1000) selon la revendication 6, dans laquelle le circuit de réinitialisation (R) comprend un transistor MOS (TR) reliant, par ses noeuds de conduction, le noeud flottant (s1) au noeud (GND) d'application du potentiel de référence de la cellule.

8. Cellule logique (800 ; 1000) selon l'une quelconque des revendications 1 à 7, comportant en outre un premier transistor MOS additionnel (T1) reliant le noeud (a1) d'application de la tension d'alimentation à un noeud flottant additionnel (s1) de fourniture d'un signal logique de sortie complémentaire (NVOUT1) de la cellule, dans laquelle le premier transistor MOS additionnel (T1) est un transistor à double grilles comportant une grille de face avant (fg) reliée à un noeud (e1) d'application d'un signal logique d'entrée complémentaire (NVIN1) de la cellule, et une grille de face arrière (bg) reliée au noeud (p1) d'application de la première tension de polarisation (p1) de la cellule.

9. Cellule logique (800 ; 1000) selon la revendication 8, comportant en outre un circuit de maintien additionnel (H), le circuit de maintien additionnel (H) comprenant un transistor MOS (TH) reliant, par ses noeuds de conduction, le noeud (a1) d'application de la tension d'alimentation au noeud flottant additionnel (s1) de la cellule.

10. Cellule logique (800 ; 1000) selon la revendication 9 dans son rattachement à la revendication 5, dans laquelle le transistor (TH) du circuit de maintien a une grille de face avant (fg) connectée au noeud flottant additionnel (s1) de la cellule et le transistor (TH) du circuit de maintien additionnel a une grille de face avant (fg) connectée au noeud flottant (s1) de la cellule.

11. Cellule logique (800 ; 1000) selon la revendication 10, dans laquelle le premier transistor (T1) et le premier transistor additionnel (T1) de la cellule sont de même type de conductivité, et dans lequel le transistor (TH) du circuit de maintien (H) et le transistor (TH) du circuit de maintien additionnel sont de type de conductivité opposé à celui du premier transistor (T1) et du premier transistor additionnel (T1).

12. Cellule logique (800 ; 1000) selon la revendication 11, dans laquelle le transistor (TH) du circuit de maintien (H) et le transistor (TH) du circuit de maintien additionnel (H) sont des transistors à double grilles ayant une grille de face arrière (bg) reliée à un noeud (p2) d'application d'une deuxième tension de polarisation variable périodique (VBGP).

13. Cellule logique (1000) selon l'une quelconque des revendications 8 à 12, comportant en outre un circuit de réinitialisation additionnel (R), le circuit de réinitialisation additionnel (R) comprenant un transistor MOS (TR) reliant, par ses noeuds de conduction, le noeud flottant additionnel (s1) au noeud (GND) d'application du potentiel de référence de la cellule.

14. Cellule logique (1000) selon la revendication 13 dans son rattachement à la revendication 7, dans laquelle le transistor (TR) du circuit de réinitialisation (R) a une grille de face avant (fg) connectée au noeud flottant additionnel (s1) de la cellule et le transistor (TR) du circuit de réinitialisation additionnel (R) a une grille de face avant (fg) connectée au noeud flottant (s1) de la cellule.

15. Cellule logique (1000) selon la revendication 14, dans laquelle le transistor (TR) du circuit de réinitialisation (R) et le transistor (TR) du circuit de réinitialisation additionnel (R) sont des transistors à double grilles ayant chacun une grille de face arrière (bg) reliée au noeud (p1) d'application de la première tension de polarisation (VBGN) de la cellule.

16. Circuit logique comportant une première cellule logique (400 ; 800 ; 1000) selon l'une quelconque des revendications 1 à 15 et une deuxième cellule logique (400 ; 800 ; 1000) selon l'une quelconque des revendications 1 à 15 cascadée en série avec la première cellule, la première cellule ayant son noeud flottant (s1) connecté au noeud (e1) d'application du signal logique d'entrée de la deuxième cellule.

Fig 1

Fig 2

Fig 3

Fig 4

Fig 5

Fig 6

Fig 7

Fig 8

Fig 9

Fig 10

Fig 11

Europäisches
Patentamt

European
Patent Office

Office européen
des brevets

**RAPPORT DE RECHERCHE EUROPEENNE**

Numéro de la demande

EP 19 20 2327

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DILESHWAR RAO L ET AL: "FinFET based adiabatic logic design for low power applications", 2017 INTERNATIONAL CONFERENCE ON MICROELECTRONIC DEVICES, CIRCUITS AND SYSTEMS (ICMDCS), IEEE, 10 août 2017 (2017-08-10), pages 1-6, XP033278782, DOI: 10.1109/ICMDCS.2017.8211535 | 1,4,5 | INV. H03K19/00 |
| A | * le document en entier * ----- | 3,14,15 | |
| X | KUMAR S DINESH ET AL: "FinSAL: A novel FinFET based Secure Adiabatic Logic for energy-efficient and DPA resistant IoT devices", 2016 IEEE INTERNATIONAL CONFERENCE ON REBOOTING COMPUTING (ICRC), IEEE, 17 octobre 2016 (2016-10-17), pages 1-8, XP032998987, DOI: 10.1109/ICRC.2016.7738710 | 1,2, 4-13,16 | |
| A | * le document en entier * ----- | 3,14,15 | **DOMAINES TECHNIQUES RECHERCHES (IPC)**<br><br>H03K |

Le présent rapport a été établi pour toutes les revendications

| Lieu de la recherche | Date d'achèvement de la recherche | Examinateur |
|---|---|---|
| Munich | 27 novembre 2019 | Mesplede, Delphine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)